(19)

Europäisches
Patentamt
European
Patent Office
Office européen
des brevets

(11) **EP 2 654 201 A2**

(12) **EUROPEAN PATENT APPLICATION**

(43) Date of publication:
  **23.10.2013 Bulletin 2013/43**

(51) Int Cl.:
  **H02P 27/00** *(2006.01)*    **H02M 7/00** *(2006.01)*

(21) Application number: **13164154.0**

(22) Date of filing: **17.04.2013**

(84) Designated Contracting States:
  **AL AT BE BG CH CY CZ DE DK EE ES FI FR GB GR HR HU IE IS IT LI LT LU LV MC MK MT NL NO PL PT RO RS SE SI SK SM TR**
  Designated Extension States:
  **BA ME**

(30) Priority: **19.04.2012  US 201261635555 P**
  **11.04.2013  US 201313860673**

(71) Applicants:
  • **Schlumberger Holdings Limited**
   **Tortola (VG)**
  • **Services Pétroliers Schlumberger**
   **75007 Paris (FR)**
  • **Schlumberger Technology B.V.**
   **2514 The Hague (NL)**

(72) Inventors:
  • **Liang, Xiadong**
   **Edmonton, Alberta T61 2H1 (CA)**
  • **Lim, Jeffrey**
   **Edmonton, Alberta T6T 1H4 (CA)**
  • **Adedun, Rotimi**
   **Edmonton, Alberta T6W 1P1 (CA)**

(74) Representative: **Bailey, Richard Alan**
  **Marks & Clerk LLP**
  **Alpha Tower**
  **Suffolk Street**
  **Queensway**
  **Birmingham B1 1TT (GB)**

(54)    **Load filters for medium voltage variable speed drives in electrical submersible pump systems**

(57)    A medium voltage drive for driving a motor of an electric submersible pump can include inverter circuitry that includes an output for output of power and a load filter connected to the output that includes inductors and capacitors that include inductance (L) and capacitance (C) values that determine a resonance frequency ($f_r$) value within a range from approximately 750 Hz to approximately 1000 Hz according to the equation $f_r = (2\pi (LC)^{0.5})^{-1}$. Various other apparatuses, systems, methods, etc., are also disclosed.

Fig. 1

**EP 2 654 201 A2**

## Description

BACKGROUND

Artificial lift equipment such as electric submersible pumps (ESPs) may be deployed for any of a variety of pumping purposes. For example, where a substance does not readily flow responsive to existing natural forces, an ESP may be implemented to artificially lift the substance. To receive power, an ESP is connected to a cable or cables, which are, in turn, connected to a power drive. In some instances, the length of such a cable or cables may be of the order of several kilometers. Choice of cable or cables as well as other equipment may impact performance of a system, particularly behavior of power output by a drive. Various technologies, techniques, etc., described herein pertain to filtering power output from a drive.

SUMMARY

A medium voltage drive for driving a motor of an electric submersible pump can include inverter circuitry that includes an output for output of power; and a load filter connected to the output that includes inductors and capacitors that include inductance (L) and capacitance (C) values that determine a resonance frequency ($f_r$) value within a range from approximately 750 Hz to approximately 1000 Hz according to the equation $f_r = (2\pi (LC)^{0.5})^{-1}$. A method can include selecting one or more criteria for a resonance frequency; selecting inductance and capacitance values for a load filter based at least in part on the one or more criteria; modeling a system that includes a medium voltage drive, the load filter, cables and an electric submersible pump driven by an electric motor to generate modeling results; analyzing the modeling results for one or more peak frequencies and for cleanliness of sinusoidal waveforms; based on the analyzing of the modeling results, deciding if the load filter is acceptable; altering one or more parameters of the cables; re- modeling the system with the one or more altered parameters of the cables to generate additional modeling results; analyzing the additional modeling results for one or more peak frequencies and for cleanliness of sinusoidal waveforms; based on the analyzing of the additional modeling results, deciding if the load filter is acceptable; and if the deciding decides that the load filter is acceptable, building the load filter, otherwise repeating at least the selecting inductance and capacitance values to select at least one different inductance or capacitance value. A system can include a medium voltage drive that includes a load filter; cables that include an overall length in a length range of approximately 25 m to approximately 25 km; and an electric submersible pump that includes an electric motor, where the load filter maintains output from the medium voltage drive at voltages below rated voltages of the cables and the electric motor. Various other apparatuses, systems, methods, etc., are also disclosed.

This summary is provided to introduce a selection of concepts that are further described below in the detailed description. This summary is not intended to identify key or essential features of the claimed subject matter, nor is it intended to be used as an aid in limiting the scope of the claimed subject matter.

BRIEF DESCRIPTION OF THE DRAWINGS

Features and advantages of the described implementations can be more readily understood by reference to the following description taken in conjunction with the accompanying drawings.

Fig. 1 illustrates an example of an electric submersible pump (ESP) system that includes a variable speed drive (VSD);

Fig. 2 illustrates an example of an ESP system that includes a VSD;

Fig. 3 illustrates examples of circuitry and an example of an equation associated with such circuitry;

Fig. 4 illustrates an example of an ESP system that includes a MVD;

Fig. 5 illustrates an example of a method;

Fig. 6 illustrates a plot of modeling results for modeling of the system of Fig. 4 without a load filter;

Fig. 7 illustrates a plot of modeling results for modeling of the system of Fig. 4 without a load filter;

Fig. 8 illustrates a plot of modeling results for modeling of the system of Fig. 4 with a load filter (Filter 1);

Fig. 9 illustrates a plot of modeling results for modeling of the system of Fig. 4 with a load filter (Filter 1);

Fig. 10 illustrates a plot of modeling results for modeling of the system of Fig. 4 with a load filter (Filter 3);

Fig. 11 illustrates a plot of modeling results for modeling of the system of Fig. 4 with a load filter (Filter 3);

Fig. 12 illustrates a plot of modeling results for modeling of the system of Fig. 4 with a load filter (Filter 4);

Fig. 13 illustrates a plot of modeling results for modeling of the system of Fig. 4 with a load filter (Filter 3, long cable);

Fig. 14 illustrates a plot of modeling results for modeling of the system of Fig. 4 with a load filter (Filter 3, long cable);

Fig. 15 illustrates a plot of modeling results for modeling of the system of Fig. 4 with a load filter (Filter 3, short cable);

Fig. 16 illustrates a plot of modeling results for modeling of the system of Fig. 4 with a load filter (Filter 3, short cable);

Fig. 17 illustrates a plot of modeling results for modeling of the system of Fig. 4 without a load filter (cascade MVD);

Fig. 18 illustrates a plot of modeling results for modeling of the system of Fig. 4 with a load filter (cascade, Filter 3);

Fig. 19 illustrates a plot of trial results for a physical system that includes a load filter; and

Fig. 20 illustrates a plot of trial results for a physical system that includes a load filter.

DETAILED DESCRIPTION

The following description includes the best mode presently contemplated for practicing the described implementations. This description is not to be taken in a limiting sense, but rather is made merely for the purpose of describing the general principles of the implementations. The scope of the described implementations should be ascertained with reference to the issued claims.

Electric submersible pumps (ESPs) may be deployed for any of a variety of pumping purposes. For example, where a substance does not readily flow responsive to existing natural forces, an ESP may be implemented to artificially lift the substance. Commercially available ESPs (such as the REDA™ ESPs marketed by Schlumberger Limited, Houston, Texas) may find use in applications that include, for example, pump rates in excess of 4,000 barrels per day and lift of 12,000 feet or more.

ESPs have associated costs, including equipment costs, replacement costs, repair costs, and power consumption costs. To assist with selection of ESP specifications, a manufacturer may provide a plot with a pump performance curve that defines an optimal operating range for a given pump speed and fluid viscosity. Such a plot may include a head-capacity curve that shows amount of lift per pump stage at a given flow rate, a horsepower requirements curve across a range of flow capacities, and a pump efficiency curve, for example, calculated from head, flow capacity, fluid specific gravity and horsepower. As an example, an ESP may be specified as having a "best efficiency point" (BEP) of about 77% for a flow of about 7,900 barrels per day, a head of about 50 feet and a horsepower of about 3.7 for a fluid specific gravity of 1.0 (e.g., REDA™ 538 Series, 1 stage at 3,500 RPM at 60 Hz). An ESP may be specified with a lift per stage such that a number of stages may be selected for an application to meet lift requirements.

An ESP or other downhole equipment may include one or more electric motors. A motor may be driven, for example, via a 3-phase power supply and a power cable or cables that provide a 3-phase AC power signal. As an example, an ESP motor may be coupled to a 3-phase power signal via a balanced inductor network having a neutral, ungrounded node, which may be referred to as a "wye node" or "wye point" of the ESP motor. Voltage and current levels of the 3-phase AC power signal provided by a power supply to an ESP motor may be, for example, of the order of several kilovolts and tens of amperes and oscillate at a frequency of the order of about 60 Hz.

Adjustments may be made to an ESP, for example, where the ESP is outfitted with a variable-speed drive (VSD) unit. A VSD unit can include an ESP controller such as, for example, the UniConn™ controller marketed by Schlumberger Limited (Houston, Texas). In combination, a VSD unit with an ESP controller allows for variations in motor speed, which may better manage power, heat, etc.

As an example, an ESP may include one or more sensors (e.g., gauges) that measure any of a variety of phenomena (e.g., temperature, pressure, vibration, etc.). A commercially available sensor is the Phoenix MultiSensor™ marketed by Schlumberger Limited (Houston, Texas), which monitors intake and discharge pressures; intake, motor and discharge temperatures; and vibration and current-leakage. An ESP monitoring system may include a supervisory control and data acquisition system (SCADA). Commercially available surveillance systems include the espWatcher™ and the LiftWatcher™ surveillance systems marketed by Schlumberger Limited (Houston, Texas), which provide for communication of data, for example, between a production team and well/field data equipment (e.g., with or without SCADA installations). Such a system may issue instructions to, for example, start, stop or control ESP speed via an ESP controller.

As to power to power a sensor (e.g., an active sensor), circuitry associated with a sensor (e.g., an active or a passive sensor), or a sensor and circuitry associated with a sensor, a DC power signal may be provided via an ESP cable and available at a wye point of an ESP motor, for example, powered by a 3-phase AC power signal. Where sufficient balance exists between the three phases of the AC power signal, the DC power signal may be sufficient for demands of one or more sensors, associated circuitry, etc.

As an example, a power cable may provide for delivery of power to an ESP, other downhole equipment or an ESP and other downhole equipment. Such a power cable may also provide for transmission of data to downhole equipment, from downhole equipment or to and from downhole equipment.

As to issues associated with ESP operations, a power supply may experience unbalanced phases, voltage spikes, presence of harmonics, lightning strikes, etc., which may, for example, increase temperature of an ESP motor, a power cable, etc.; a motor controller may experience issues when subjected to extreme conditions (e.g., high/low temperatures, high level of moisture, etc.); an ESP motor may experience a short circuit due to debris in its lubricating oil, water breakthrough to its lubricating oil, noise from a transformer which results in wear (e.g., insulation, etc.), which may lead to lubricating oil contamination; and a power cable may experience a issues (e.g. short circuit or other) due to electric discharge in insulation surrounding one or more conductors (e.g., more probable at higher voltages), poor manufacturing quality (e.g., of insulation, armor, etc.), water breakthrough, noise from a transformer, direct physical damage (e.g., crushing, cutting, etc.) during running or pulling operations), chemical damage (e.g., corrosion), deterioration due to high temperature, current above a design limit resulting in temperature increase, electrical stresses, etc.

As an example, a power supply may include a load filter that may be suitable for various types of arrangements. For example, a load filter may be provided that can provide for clean waveforms with reduced risks of spikes, undesirable resonant conditions, etc., for various types of power cables, cable lengths, etc. As an example, a load filter may be configured as a wye with inductors and capacitors. In such an example, selection of the inductors and capacitors may reduce risk of undesirable spikes, resonance, etc., which may stress or even damage equipment.

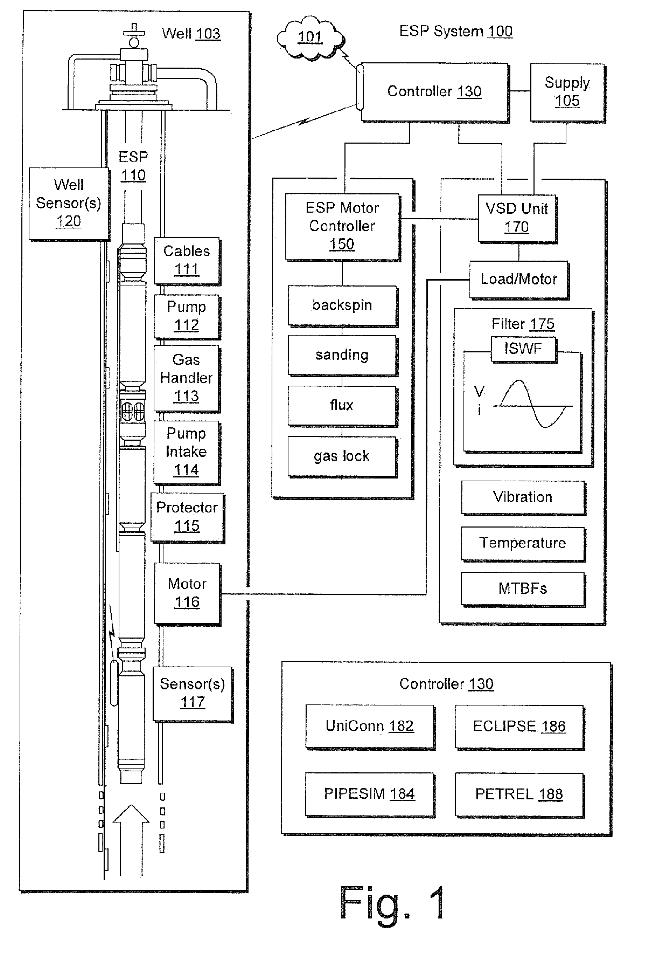

Fig. 1 shows an example of an ESP system 100 as including a network 101, a well 103 disposed in a geologic environment, a power supply 105, an ESP 110, a controller 130, a motor controller 150 and a VSD unit 170. The power supply 105 may receive power from a power grid, an onsite generator (e.g., natural gas driven turbine), or other source.

In the example of Fig. 1, the well 103 includes a wellhead that can include a choke (e.g., a choke valve). For example, the well 103 can include a choke valve to control various operations such as to reduce pressure of a fluid from high pressure in a closed wellbore to atmospheric pressure. Adjustable choke valves can include valves constructed to resist wear due to high-velocity, solids-laden fluid flowing by restricting or sealing elements. A wellhead may include one or more sensors such as a temperature sensor, a pressure sensor, a solids sensor, etc.

The ESP 110 includes cables 111, a pump 112, gas handling features 113, a pump intake 114, a protector 115, a motor 116, and one or more sensors 117 (e.g., temperature, pressure, current leakage, vibration, etc.). The well 103 may include one or more well sensors 120, for example, such as the commercially available OpticLine™ sensors or WellWatcher BriteBlue™ sensors marketed by Schlumberger Limited (Houston, Texas). Such sensors are fiber-optic based and can provide for real time sensing of temperature, for example, in steam-assisted gravity drainage (SAGD) or other operations (e.g., enhanced oil recovery, etc.). With respect to SAGD, as an example, a well may include a relatively horizontal portion. Such a portion may collect heated heavy oil responsive to steam injection and an ESP may be positioned horizontally to enhance flow of the heavy oil.

In the example of Fig. 1, the controller 130 can include one or more interfaces, for example, for receipt, transmission or receipt and transmission of information with the motor controller 150, a VSD unit 170, the power supply 105 (e.g., a gas fueled turbine generator, a power company, etc.), the network 101, equipment in the well 103, equipment in another well, etc.

As shown in Fig. 1, the controller 130 can include or provide access to one or more modules or frameworks. Further, the controller 130 may include features of an ESP motor controller and optionally supplant the ESP motor controller 150. For example, the controller 130 may include the UniConn™ motor controller 182 marketed by Schlumberger Limited (Houston, Texas). In the example of Fig. 1, the controller 130 may access one or more of the PIPESIM™ framework 184 marketed by Schlumberger Limited (Houston, Texas), the ECLIPSE™ framework 186 marketed by Schlumberger Limited (Houston, Texas) and the PETREL™ framework 188 marketed by Schlumberger Limited (Houston, Texas).

In the example of Fig. 1, the motor controller 150 may be a commercially available motor controller such as the UniConn™ motor controller. The UniConn™ motor controller can connect to a SCADA system, the espWatcher™ surveillance system marketed by Schlumberger Limited (Houston, Texas), etc. The UniConn™ motor controller can perform some control and data acquisition tasks for ESPs, surface pumps or other monitored wells. The UniConn™ motor controller can interface with the Phoenix™ monitoring system marketed by Schlumberger Limited (Houston, Texas), for example, to access pressure, temperature and vibration data and various protection parameters as well as to provide direct current power to downhole sensors. The UniConn™ motor controller can interface with fixed speed drive (FSD) controllers or a VSD unit, for example, such as the VSD unit 170.

For FSD controllers, the UniConn™ motor controller can monitor ESP system three-phase currents, three-phase surface voltage, supply voltage and frequency, ESP spinning frequency and leg ground, power factor and motor load.

For VSD units, the UniConn™ motor controller can monitor VSD output current, ESP running current, VSD output voltage, supply voltage, VSD input and VSD output power, VSD output frequency, drive loading, motor load, three-phase ESP running current, three-phase VSD input or output voltage, ESP spinning frequency, and leg-ground.

The UniConn™ motor controller can include control functionality for VSD units such as target speed, minimum and maximum speed and base speed (voltage divided by frequency); three jump frequencies and bandwidths; volts per hertz pattern and start-up boost; ability to start an ESP while the motor is spinning; acceleration and deceleration rates, including start to minimum speed and minimum to target speed to maintain constant pressure/load (e.g., from 0.01 Hz/10,000 s to 1 Hz/s); stop mode with pulse-width modulated (PWM) carrier frequency; base speed voltage selection; rocking start frequency, cycle and pattern control; stall protection with automatic speed reduction; changing motor rotation direction without stopping; speed force; speed follower mode; frequency control to maintain constant speed, pressure or load; current unbalance; voltage unbalance; overvoltage and undervoltage; ESP backspin; and leg-ground.

In the example of Fig. 1, the ESP motor controller 150 includes various modules to handle, for example, backspin of an ESP, sanding of an ESP, flux of an ESP and gas lock of an ESP. As mentioned, the motor controller 150 may include any of a variety of features, additionally, alternatively, etc.

In the example of Fig. 1, the VSD unit 170 may be a medium voltage drive (MVD) unit. For a MVD, a VSD unit can include an integrated transformer and control circuitry. As an example, the VSD unit 170 may receive power with a voltage of about 4.16 kV and control a motor as a load with a voltage from about 0 V to about 4.16 kV. As an example, a MVD VSD unit may operate using voltage levels up to about 6 kV. In contrast, a low voltage drive (LVD) may operate with three phase, multilevel PWM in a range from about 0 V to an input voltage level, which may be, for example, about 380 V or, for example, up to about 480 V. As an example, a range for a MVD may be from about 1 kV to about 6 kV.

The VSD unit 170 may include commercially available control circuitry such as the SpeedStar™ MVD control circuitry marketed by Schlumberger Limited (Houston, Texas). The SpeedStar™ MVD control circuitry is suitable for indoor or outdoor use and may include a visible fused disconnect switch, precharge circuitry, and sine wave output filter 175 (e.g., integral sine wave filter, ISWF) tailored for control and protection of ESP circuitry (e.g., an ESP motor). As an example, the SpeedStar™ MVD control circuitry can include the sine wave output filter 175 as a plug-and-play filter and can include a multilevel PWM inverter output, a 0.95 power factor, programmable load reduction (e.g., soft-stall function), speed control circuitry to maintain constant load or pressure, rocking start (e.g., for stuck pumps resulting from scale, sand, etc.), a utility power receptacle, an acquisition system for the Phoenix™ monitoring system, a site communication box to support surveillance and control service, a speed control potentiometer. The SpeedStar™ MVD control circuitry can optionally interface with the UniConn™ motor controller, which may provide some of the foregoing functionality.

In the example of Fig. 1, the VSD unit 170 is shown along with a plot of a sine wave (e.g., achieved via the sine wave output filter 175) and modules that may provide for responsiveness to vibration, responsiveness to temperature and management to reduce mean time between failures (MTBFs). As an example, the VSD unit 170 may be rated with an ESP to provide for about 40,000 hours (5 years) of operation at a temperature of about 50 C with about a 100% load. The VSD unit 170 may include surge and lightening protection (e.g., one protection circuit per phase). With respect to operational cost, as an example, for a 373 kW load, an increase in efficiency of about 0.5% may translate into about $1,000 per year in power savings (e.g., depending on cost of power). As to leg-ground monitoring or water intrusion monitoring, such types of monitoring can indicate whether corrosion is or has occurred. Further monitoring of power quality from a supply, to a motor, at a motor, may occur by one or more circuits or features of a controller.

As an example, a VSD unit may change its base speed (commonly known as the output Volts/Hz ratio) when running an ESP motor. The base speed of a VSD unit is described as the point at which the VSD unit reaches it maximum output voltage at a specified frequency. As an example, a motor can be optimized by adjusting the voltage delivered to a motor according to load.

Overall system efficiency can affect power supply from the utility or generator. As described herein, monitoring of current total harmonic distortion (ITHD), voltage total harmonic distortion (VTHD), power factor (PF) and overall efficiency may occur (e.g., surface measurements). Such surface measurements may be analyzed in separately or optionally in conjunction with a pump curve. VSD unit related surface readings (e.g., at an input to a VSD unit) can optionally be input to an economics model. For example, the higher the PF and therefore efficiency (e.g., by running an ESP at a higher frequency and at close to 100% load), the less harmonics current (lower ITHD) sensed by the power supply. In such an example, well operations can experience less loses and thereby lower energy costs for the same load.

While the example of Fig. 1 shows an ESP with centrifugal pump stages, another type of ESP may be controlled. For example, an ESP may include a hydraulic diaphragm electric submersible pump (HDESP), which is a positive-displacement, double-acting diaphragm pump with a downhole motor. HDESPs find use in low-liquid-rate coalbed methane and other oil and gas shallow wells that may implement artificial lift to remove water from the wellbore. A HDESP can be set above or below the perforations and run in wells that are, for example, less than about 2,500 ft deep and that produce less than about 200 barrels per day. HDESPs may handle a wide variety of fluids and, for example, up to about 2% sand, coal, fines and $H_2S/CO_2$. As to materials of construction, materials such as, for example, those used in commercially available REDA™ or other submersible pumps for use in the oil and gas industry may be used.

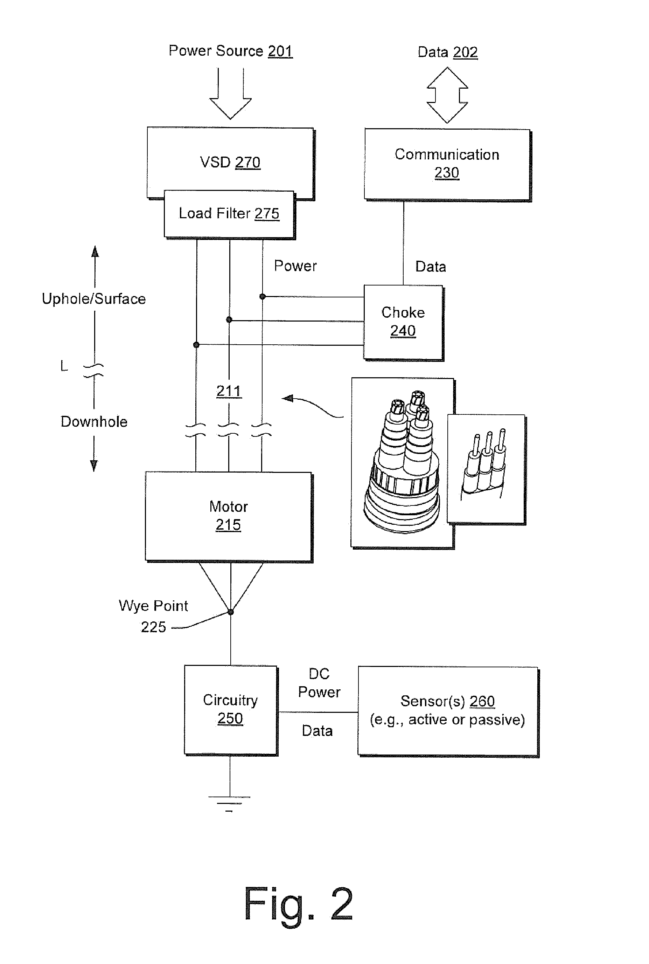

Fig. 2 shows a block diagram of an example of a system 200 that includes a power source 201 as well as data 202. The power source 201 provides power to a VSD block 270 with a load filter 275 while the data 202 may be provided to a communication block 230. The data 202 may include instructions, for example, to instruct circuitry of the circuitry block 250, one or more sensors of the sensor block 260, etc. The data 202 may be or include data communicated, for example, from the circuitry block 250, the sensor block 260, etc. In the example of Fig. 2, a choke block 240 can provide for transmission of data signals via a power cable 211 (e.g., including motor lead extensions "MLEs"). A power cable may be provided in a format such as a round format or a flat format with multiple conductors. MLEs may be spliced onto a power cable to allow each of the conductors to physically connect to an appropriate corresponding connector of an electric motor.

As shown, the power cable 211 connects to a motor block 215, which may be a motor (or motors) of an ESP and be controllable via the VSD block 270. In the example of Fig. 2, the conductors of the power cable 211 electrically connect at a wye point 225. The circuitry block 250 may derive power via the wye point 225 and may optionally transmit, receive or transmit and receive data via the wye point 225. As shown, the circuitry block 250 may be grounded.

As an example, power cables and MLEs that can resist damaging forces, whether mechanical, electrical or chemical, may help ensure proper operation of a motor, circuitry, sensors, etc.; noting that a faulty power cable (or MLE) can potentially damage a motor, circuitry, sensors, etc. Further, as mentioned, an ESP may be located several kilometers into a wellbore. Accordingly, time and cost to replace a faulty ESP, power cable, MLE, etc., can be substantial (e.g., time to withdraw, downtime for fluid pumping, time to insert, etc.).

Commercially available power cables include the REDAMAX™ Hotline™ ESP power cables (e.g., as well as motor lead extensions "MLEs"), which are marketed by Schlumberger Limited (Houston, Texas). As an example, a REDAMAX™ Hotline™ ESP power cable can include combinations of polyimide tape, lead, EPDM, and PEEK to provide insulation and a jacket. Lead walls can provide for compatibility with high gas/oil ratio (GOR) and highly corrosive conditions. Armor can mechanically protect the cable and may be galvanized steel, heavy galvanized steel, stainless steel, or Monel® alloy. The pothead is an electrical connector between a cable and an ESP motor that may be constructed with metal-to-metal seals. A pothead can provide a mechanical barrier to fluid entry in high-temperature applications.

As an example of a REDAMAX™ Hotline™ ESP power cable, a 5 kV round ELBE G5R can include solid conductor sizes of 1 AWG/1, 2 AWG/1 and 4 AWG/1. As another example, a 5 kV flat EHLTB G5F can include a solid conductor size of 4 AWG/1. Dimensions may be, for round configurations, about 1 to 2 inches in diameter and, for flat configurations, about half an inch by about 1 to 2 inches. For such example configurations, weights may range from about 1 lbm/ft to about 3 lbm/ft.

As to understanding resonance conditions in an ESP system, various factors may come into play such as, for example, cleanliness of power signal, length of cable, cable connections, environmental conditions, etc. Resonance at the output of a medium voltage drive may amplify voltage harmonics if these harmonics hit a resonance point, which can, in turn, cause excessive voltage spikes on downhole cable(s), an electric submersible motor, etc.

As an example, consider that some commercially available MVDs use multi-level PWM techniques, and the harmonics at the drive output are much smaller compared to the 2-level low voltage PWM inverter type drives, thus for a surface motor application, a load filter may be omitted for MVD applications. However, as described herein, in various examples, for ESP/subsea-ESP systems, a load filter may be provided.

Different configurations for ESP/subsea-ESP systems, for example, to adapt to the physical environment, operational conditions, EOR, etc., resonance conditions may differ from system to system. To protect such systems, as an example, a load filter may be connected to an output circuit of a drive, for example, to attenuate harmonic resonance and mitigate harmonics from the drive. Such a filter may, for example, work for system configurations with various lengths of subsea cables and/or downhole cables. As an example, such a filter may be provided with a drive (e.g., as part of the drive) where it may be suitable for various arrangements of cables, motors, etc. For example, a MVD may be supplied with an effective load filter suitable for various length of cabling for ESP system applications, which may, in turn, widen applications of MVDs in the oil and gas industry.

As an example, a load filter may be connected to the output of a MVD where the MVD may be one of a MVD characterized by neutral-clamped multi-level pulse-width modulation (PWM) inverters or of a MVD characterized by cascaded multi-level inverters. As an example, for subsea operations, such a filter may be included in circuitry that includes a cable length or cable lengths that extend to an ESP. For example, such a filter may be included in a system that includes overall cable length of up to about 50 km.

As to an inverter, a main power circuit of a MVD VSD may include diodes and insulated gate bipolar transistors (IGBTs) configured to provide full-wave diode rectification and IGBT inversion circuitry for output of multi-level PWM waveforms (e.g., without neutral shift).

As an example, a load filter may receive input and filter that input to output a sinusoidal waveform. Without such a load filter (e.g., an unfiltered scenario), harmonic resonance may occur in an ESP system and result in downhole equipment being exposed to large voltage spikes.

As power disturbances can affect run life of a system (e.g., MTBF), a load filter may be applied to provide a clean (e.g., "smooth") harmonics-mitigated sine wave that, in turn, can lessen system stress. Such a filter may, when applied to a MVD and compared to an unfiltered MVD, prolong run life of an ESP system. In general, as overall system length and depth increase (e.g., which may be substantial in subsea operations), adequate load filtering for production of sinusoidal waveforms can provide many benefits.

As to harmonics, consider a waveform with a frequency of 60 Hz, which may be considered a fundamental frequency. Such a waveform may include a harmonic at 1850 Hz, which, in turn, can form a distorted waveform when combined with the fundamental frequency of 60 Hz. As an example, a load filter may filter input to avoid or dampen harmonics, which, in turn, provide a cleaner, less distorted waveform (e.g., a waveform resembling a pure fundamental frequency).

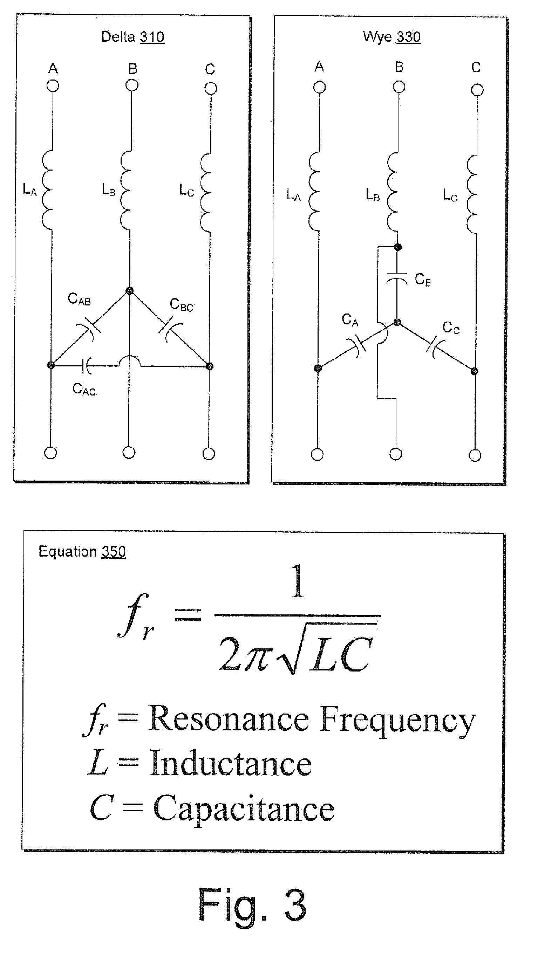

Fig. 3 shows an example of a delta circuit 310, a wye circuit 330 and an equation 350. The delta circuit 310 and the wye circuit 330 are LC type sine wave filter circuits. As an example, a load filter may be configured as a wye circuit, for example, such as the wye circuit 330. For use in a system with a drive, cable and pump, such a load filter may be provided with selected inductance (L) and capacitance (C) values suitable for various cable lengths, number of cables, etc.; noting that improper selection of L and C values may cause serious resonance in a system, which could result in the damage of one or more downhole pieces of equipment such as, for example, a main cable, a motor lead extension (MLE) cable or an electric submersible motor.

As an example, a load filter may be connected to output from an inverter section of a MVD, which is configured for use with various types of ESP systems and various types of subsea ESP systems. As an example, inductance and capacitance for such a load filter may be understood, in part, with respect to the equation 350 of Fig. 3 where L is the inductance of the load filter, C is the capacitance of the load filter and $f_r$ is a resonant frequency.

As an example, a criterion or criteria may be selected as to frequency to then be used in choosing one or more pairs of inductance and capacitance values. As an example, consider selecting the following criteria: $f_r$ is within a frequency range of about 750 Hz to about 1000 Hz. In such an example, the upper frequency value (e.g., upper criterion) may be about 1000 Hz such that a load filter may be appropriate for MVDs characterized by neutral clamped PWM technology, for example, as exceeding this upper limit could introduce resonance conditions in an ESP system.

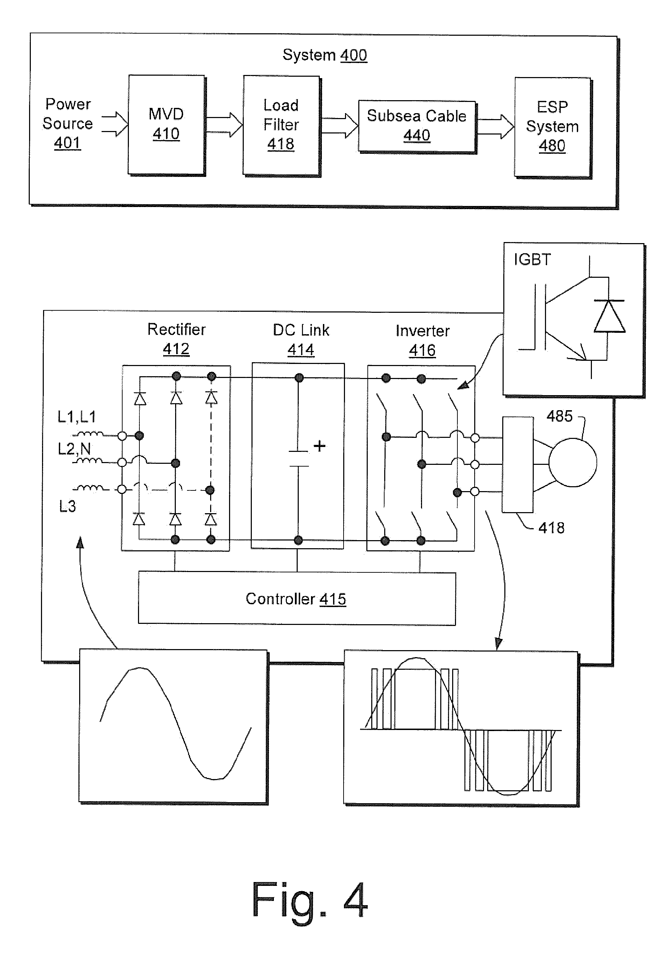

Fig. 4 shows an example of a system 400 that includes a MVD 410, a load filter 418, a cable 420, a subsea cable 440 and an ESP system 480. As an example, the subsea cable 440 may be about 2.5 km in length and the ESP system 480 may include a downhole cable that is about 2.5 km in length. As to the MVD 410, it may be, for example, a MVD that includes five-level neutral-clamped PWM circuitry or it may be, for example, a MVD that includes cascade circuitry.

As an example, the MVD 410 may include a rectifier 412, a DC link 414, a controller 415 and an inverter 416, which may include IGBTs. As indicated in the example of Fig. 4, the load filter 418 may be operatively coupled to output from the inverter 416, for example, to help protect equipment such as a motor 484 of the ESP system 480. As shown in the example of Fig. 4, an MVD may include a front end diode rectifier (e.g., AC power source to DC) 412 and a back end PWM controlled IGBT inverter (e.g., DC to "AC") 416, where the load filter 418 connects to the output of the back end PWM controlled IGBT inverter 416 to damp harmonics that can result from switching of the IGBTs.

As an example, input of a MVD may include harmonics, for example, which may be mitigated by pulse phase-shifting transformers (e.g., 24 pulse, etc.), while output of a MVD may include harmonics, for example, which may be mitigated by a load filter such as the load filter 418.

Various components of the system 400 were used to create a model for modeling behavior given one or more criteria and selected inductance and capacitance values for the load filter 418.

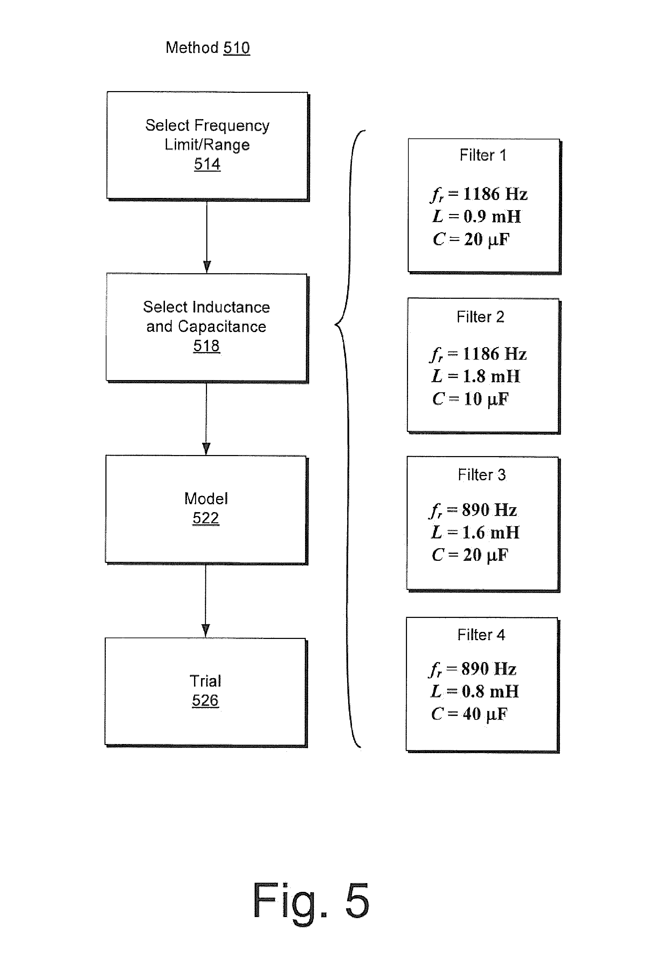

Fig. 5 shows an example of a method 510 that includes a selection block 514 for selecting a frequency limit or frequency range, a selection block 518 for selecting inductance and capacitance for a load filter, a modeling block 522 for modeling a system using the selected inductance and capacitance and a trial block 526 for performing one or more trials using the load filter, for example, on a physical system.

Fig. 5 also shows a series of filters as Filter 1, Filter 2, Filter 3 and Filter 4. The L and C values for Filters 1 and 2 correspond to $f_r$ of about 1186 Hz while the L and C values for Filters 3 and 4 correspond to $f_r$ of about 890 Hz (e.g., within a range of 750 Hz to 1000 Hz). Specifically, Filter 1 has $f_r$ = 1186 Hz, L = 0.9 mH, and C = 20 $\mu$F; Filter 2 has $f_r$ = 1186 Hz, L = 1.8 mH, and C = 10 $\mu$F; Filter 3 has $f_r$ = 890 Hz, L = 1.6 mH, and C = 20 $\mu$F; and Filter 4 has $f_r$ = 890 Hz, L = 0.8 mH, and C = 40 $\mu$F. As demonstrated in various figures that follow, when applied to the system 400 of Fig. 4, Filter 3 and Filter 4 performed adequately and are deemed suitable for use with a MVD that supplies energy to an ESP system. For example, Filter 3 and Filter 4 may be considered as being capable of providing sufficiently "clean" sinusoidal waveforms (e.g., close to sinusoidal as may be demonstrated by various plots herein). Further, modeling demonstrates that various parameters of an ESP system may be changed and that Filter 3 and Filter 4 still perform adequately. In this regard, Filter 3 and Filter 4 may be deemed "universal" load filters in that each of these filters can be applied to output from a MVD and perform adequately over a range of ESP system parameter values (e.g., cable lengths, etc.).

Modeling was performed for a system with no filter, Filter 1 and Filter 2 using $f_r$ = 1186 Hz for a MVD with five level neutral camped PWM circuitry. The results of the modeling illustrate some potential consequences of using an improper load filter. For MVDs using cascade PWM technology, although a larger $f_r$ value exceeding about 1000 Hz may be acceptable due to different harmonic voltage spectrums from multi-level neutral clamped PWM drives, a load filter with a selection criterion of a limit of about 1000Hz may produce an acceptable result.

As to a lower limit as a criterion, a limit of about 750 Hz was selected for various modeling runs; noting that it may be further reduced, for example, modeling demonstrated that a load filter may still remain effective for $f_r$=600Hz. However, smaller $f_r$ values mean that larger inductance values and/or larger capacitance values should be implemented. For a physical load filter, these larger value inductors and/or capacitors are connected to form a circuit; noting that a larger inductance can introduce a larger voltage drop and increase footprint of a filter and that a larger capacitance might result in excessive current flow during some transient conditions. To avoid detrimental consequences of excessive inductance and/or capacitance, as an example, a method can include selecting as a lower limit $f_r$ of about 750 Hz.

As examples, various values are presented for inductance L and capacitance C combinations for a load filter (e.g., or load filters) in the tables (Tables 1, 2, 3 and 4) that follow.

Table 1

| L, mH | C, μF | fr, Hz |
|---|---|---|
| 1.3 | 20 | 987.0370731 |
| 1.4 | 20 | 951.1327227 |
| 1.5 | 20 | 918.881508 |
| 1.6 | 20 | 889.7031944 |
| 1.7 | 20 | 863.1388814 |
| 1.8 | 20 | 838.8202161 |
| 1.9 | 20 | 816.4476451 |
| 2 | 20 | 795.774729 |
| 2.1 | 20 | 776.5966161 |
| 2.2 | 20 | 758.7414336 |

Table 2

| L, mH | C, μF | fr, Hz |
|---|---|---|
| 1.1 | 25 | 959.7404341 |
| 1.2 | 25 | 918.881508 |
| 1.3 | 25 | 882.8327967 |
| 1.4 | 25 | 850.7189695 |
| 1.5 | 25 | 821.8726061 |
| 1.6 | 25 | 795.774729 |
| 1.7 | 25 | 772.0148852 |
| 1.8 | 25 | 750.2636096 |

Table 3

| L, mH | C, μF | fr, Hz |
|---|---|---|
| 0.9 | 30 | 968.5861551 |
| 1 | 30 | 918.881508 |
| 1.1 | 30 | 876.1191419 |
| 1.2 | 30 | 838.8202161 |

(continued)

| L, mH | C, μF | fr, Hz |
|---|---|---|
| 1.3 | 30 | 805.9123954 |
| 1.4 | 30 | 776.5966161 |
| 1.5 | 30 | 750.2636096 |

Table 4

| L, mH | C, μF | fr, Hz |
|---|---|---|
| 0.8 | 40 | 889.7031944 |
| 0.9 | 40 | 838.8202161 |
| 1 | 40 | 795.774729 |
| 1.1 | 40 | 758.7414336 |

As an example, inductance L may be in a range from about 0.8mH to about 2.2mH; while corresponding capacitance C may be in a range from about 20μF to about 40μF, for example, to make the resonance frequency $f_r$ fall into a range of about 750 Hz to about 1000 Hz.

As an example, a medium voltage drive for driving a motor of an electric submersible pump can include inverter circuitry that includes an output for output of power and a load filter connected to the output that includes inductors and capacitors that have inductance (L) and capacitance (C) values that determine a resonance frequency ($f_r$) value within a range from approximately 750 Hz to approximately 1000 Hz according to the equation $f_r = (2\pi (LC)^{0.5})^{-1}$. As an example, the output of the inverter circuitry may output a voltage up to approximately 6 kV. As to the inductance and capacitance values, as an example, an inductance value may be in a range from approximately 0.8 mH to approximately 2.2 mH and a capacitance value may be in a range from approximately 20 μF to approximately 40 μF.

As an example, a medium voltage drive may include inverter circuitry that outputs a multi-level pulse-width modulated voltage signal. In such an example, inductors and capacitors of a load filter may filter the multi-level pulse-width modulated voltage signal to generate a waveform that approximates a sinusoidal waveform (see, e.g., various plots herein for some examples of acceptable sinusoidal waveforms).

As an example, a medium voltage drive may include a load filter with inductors and capacitors having inductance and capacitance values of approximately 1.6 mH and approximately 20 μF, respectively. In such an example, a corresponding resonance frequency value may be approximately 890 Hz.

As an example, a medium voltage drive may include a load filter with inductors and capacitors having inductance and capacitance values of approximately 0.8 mH and approximately 40 μF, respectively. In such an example, a corresponding resonance frequency value may be approximately 890 Hz.

As an example, a medium voltage drive may output power signals that have a frequency in a range from approximately 0 Hz to approximately 120 Hz.

As an example, a method can include selecting one or more criteria for a resonance frequency; selecting inductance and capacitance values for a load filter based at least in part on the one or more criteria; modeling a system that includes a medium voltage drive, the load filter, cables and an electric submersible pump driven by an electric motor to generate modeling results; analyzing the modeling results for one or more peak frequencies and for cleanliness of sinusoidal waveforms; based on the analyzing of the modeling results, deciding if the load filter is acceptable; altering one or more parameters of the cables; re-modeling the system with the one or more altered parameters of the cables to generate additional modeling results; analyzing the additional modeling results for one or more peak frequencies and for cleanliness of sinusoidal waveforms; based on the analyzing of the additional modeling results, deciding if the load filter is acceptable; and if the deciding decides that the load filter is acceptable, building the load filter, otherwise repeating at least the selecting inductance and capacitance values to select at least one different inductance or capacitance value. As an example, in such a method selecting may select one or more criteria for a resonance frequency may include selecting a lower limit of approximately 750 Hz and selecting an upper limit of approximately 1000 Hz.

As an example, a method can include analyzing modeling results for one or more peak frequencies by comparing a voltage for one of the one or more peak frequencies to a voltage limit of a physical piece of equipment for use in a system that includes a medium voltage drive, cables and an electric submersible pump driven by an electric motor.

As an example, a system can include a medium voltage drive that includes a load filter; cables that have an overall length in a length range of approximately 25 m to approximately 25 km; and an electric submersible pump that includes an electric motor, where the load filter maintains output from the medium voltage drive at voltages below rated voltages of the cables and the electric motor. In such an example, the medium voltage drive may be configured to output voltages up to approximately 6 kV. As an example, a system may include a load filter that includes inductors and capacitors that have inductance (L) and capacitance (C) values that determine a resonance frequency ($f_r$) value within a range from approximately 750 Hz to approximately 1000 Hz according to the equation $f_r = (2\pi\,(LC)^{0.5})^{-1}$ where the inductance (L) has an inductance value in a range from approximately 0.8 mH to approximately 2.2 mH and where the capacitance (C) has a capacitance value in a range from approximately 20 $\mu$F to approximately 40 $\mu$F.

As an example, a system may include a load filter that includes inductance and capacitance values of approximately 1.6 mH and approximately 20 $\mu$F, respectively. In such an example, a resonance frequency value may be approximately 890 Hz.

As an example, a system may include a load filter that includes inductance and capacitance values of approximately 0.8 mH and approximately 40 $\mu$F, respectively. In such an example, a resonance frequency value may be approximately 890 Hz.

Referring again to modeling, a modeling case, referred to as Case 1, included using a MVD using five-level neutral-clamped PWM technique. When the output of the MVD for Case 1 has no universal load filter, the peak voltage at the downhole main cable is about 10144 V vs. the peak voltage rating of about 7070 V of the cable. Similarly, the peak voltage at the ESP motor is about 10752 V versus the peak voltage rating of about 7070 V of the motor. Such high voltage spikes threaten the insulation of the downhole equipment, and therefore, as described in various examples herein, a load filter may be installed at the output of the drive to reduce risk of occurrence of such spikes and consequently to reduce risk of damage to downhole equipment.

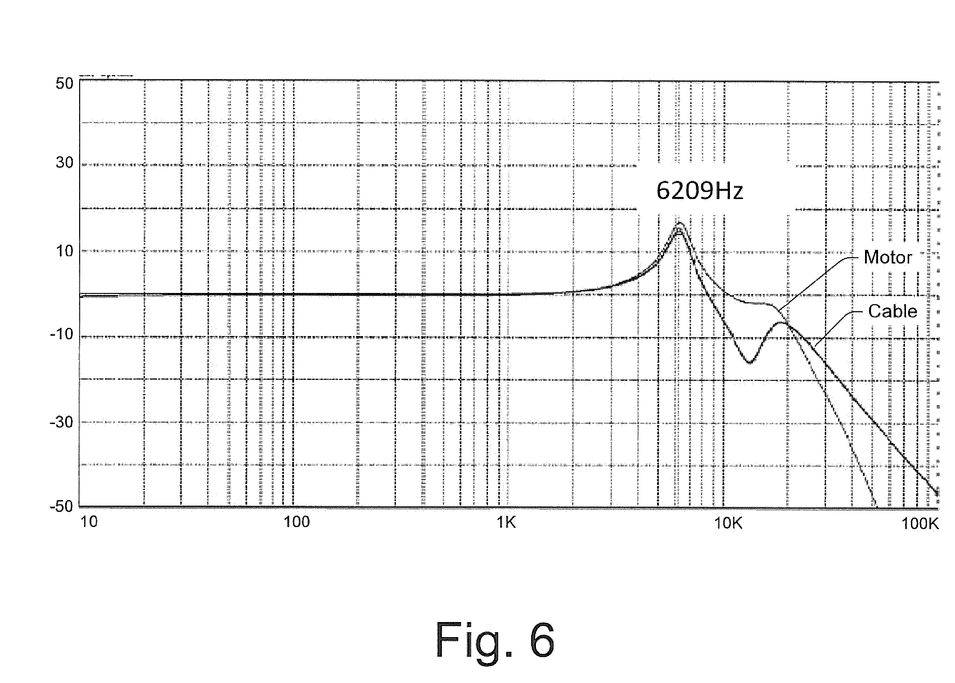

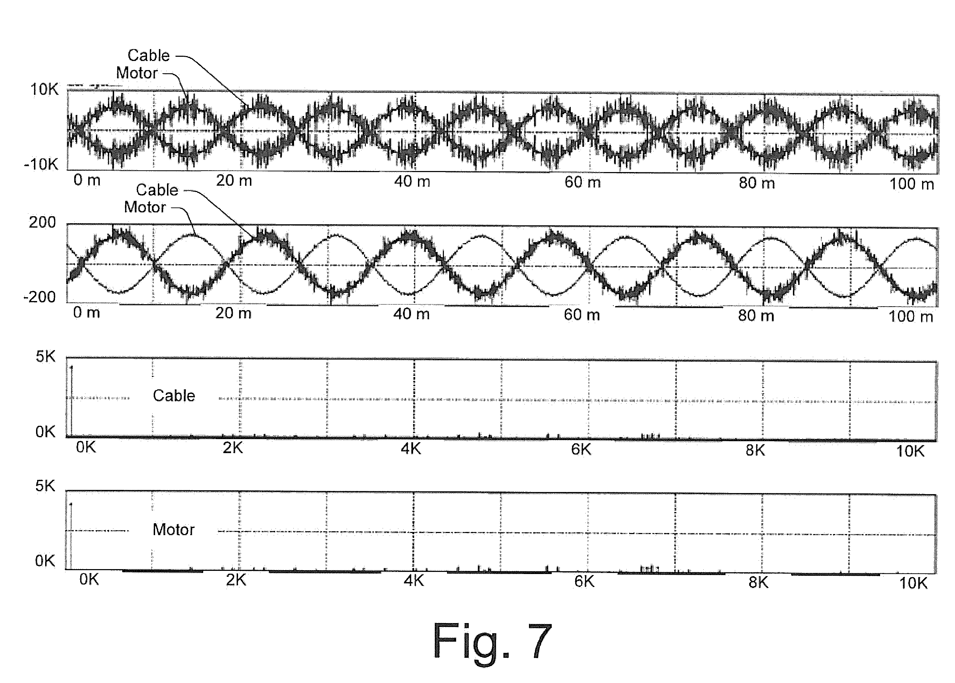

For Case 1, the natural frequency response characteristic of the system without a load filter is shown in Fig. 6, where its natural resonance frequency is at about 6209 Hz. For Case 1, the voltage and current waveforms at the downhole cable and the ESP motor are shown in Fig. 7.

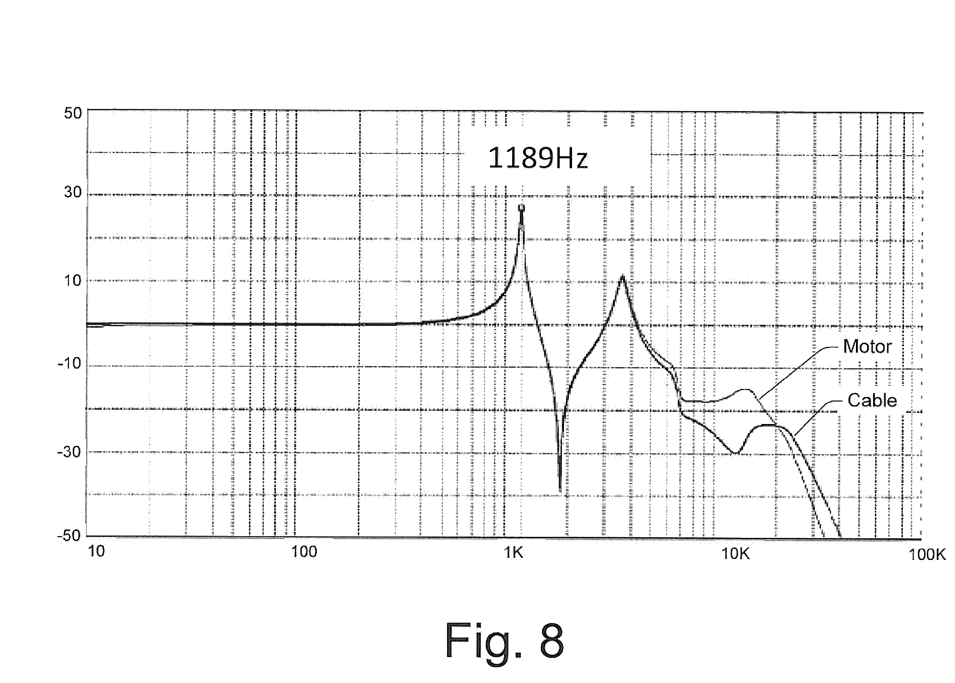

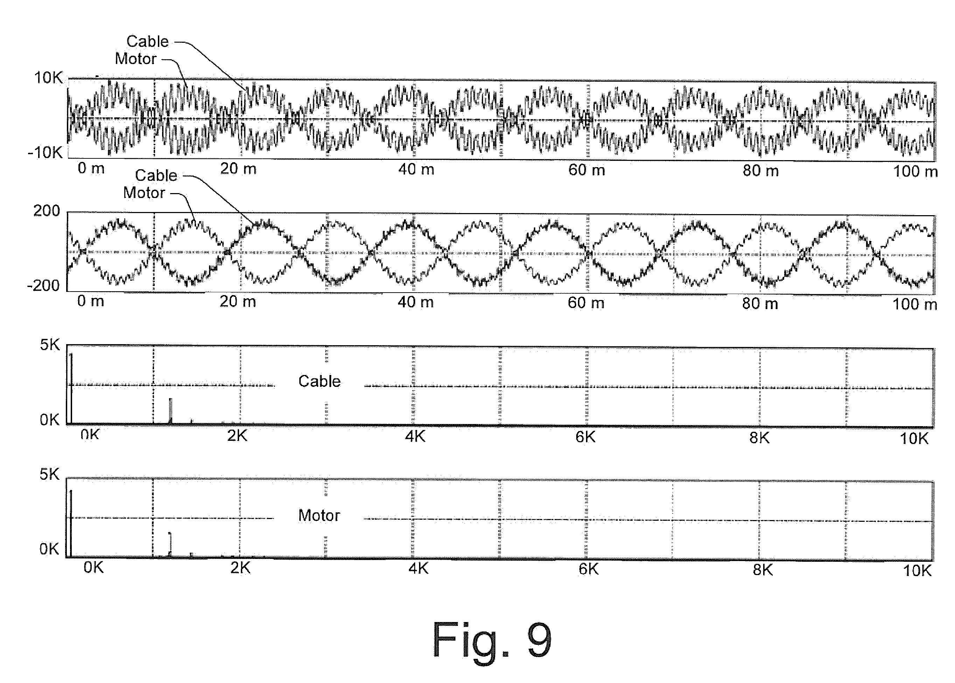

As mentioned with respect to Fig. 5, four different load filters (Filters 1, 2, 3 and 4) were applied to a model of an MVD, for example, the MVD of Case 1. For Filter 1 connected to the output of the drive, the frequency response characteristic of the system is shown in Fig. 8, and its resonance frequency is shifted to about 1189 Hz. Using Filter 1 in the system, the peak voltage at the downhole main cable is about 9734 V versus the peak voltage rating of about 7070 V of the cable. Similarly, the peak voltage at the ESP motor is about 8888 V versus the peak voltage rating of about 7070 V of the motor. For Filter 1, the voltage and current waveforms at the downhole cable and the ESP motor are shown in Fig. 9. Based on the modeling results, Filter 1 is not effective for the system 400 shown in Fig. 4.

As to Filter 2, modeling was performed to determine if the selected values of L and C could have an impact on filter effectiveness. With Filter 2 connected to the output of the drive 410 of the system 400 of Fig. 4, the frequency response characteristic shows a resonance frequency at about 1189 Hz; noting that in comparison to Filter 1, there is a second peak value. Modeling results show that by using Filter 2 in the system 400, the peak voltage at the downhole main cable is about 8405 V versus the peak voltage rating 7070V of the cable. Similarly, the peak voltage at the ESP motor is about 7881 V versus the peak voltage rating of about 7070 V of the motor. The voltage and current waveforms from the modeling of Filter 2 were quite similar those shown in Fig. 9. Therefore, based on the modeling results, Filter 2 is not effective for the system 400 shown in Fig. 4.

The modeling results for Filters 1 and 2 show that changing the L and C values change the peak voltage values in the system response, however, as the $f_r$ value is out of the proposed upper limit of about 1000 Hz, Filters 1 and 2 fail to perform adequately. Therefore, the upper limit of about 1000 Hz is imposed for selection of L and C values for a load filter; noting that a lower limit of about 750 Hz may also be applied to provide a range of about 750 Hz to about 1000 Hz.

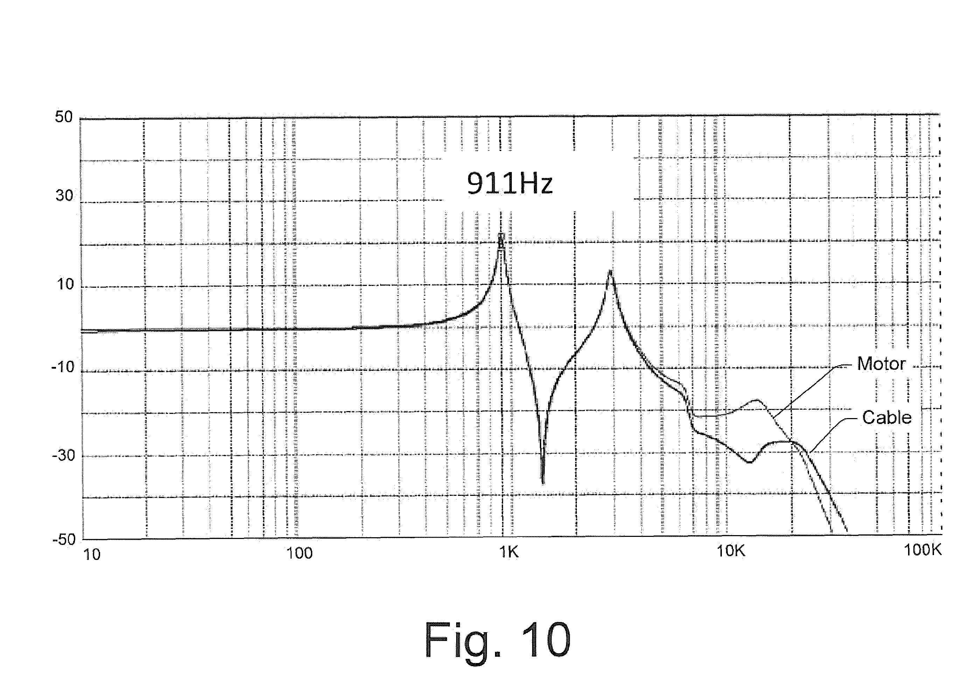

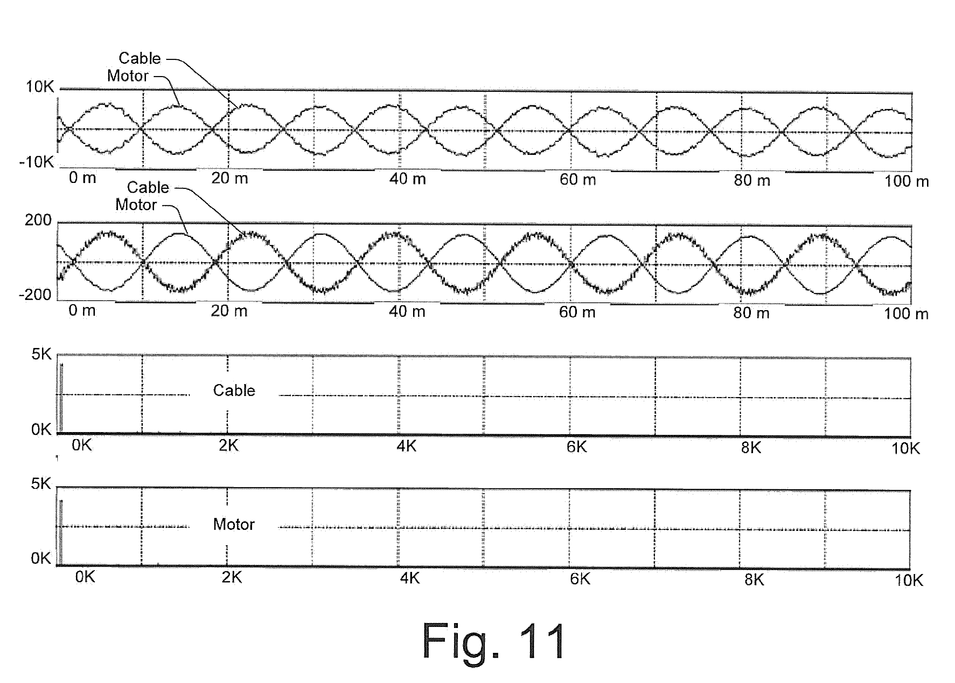

As to Filter 3, modeling was performed for the system 400 of Fig. 4 and the frequency response characteristics are shown in Fig. 10. As shown in Fig. 10, the resonance frequency is shifted to about 911 Hz. Further, the peak voltage at the downhole main cable is about 6580 V versus the peak voltage rating of about 7070 V of the cable, and the peak voltage at the ESP motor is about 6146 V versus the peak voltage rating of about 7070 V of the motor. The voltage and current waveforms of the downhole equipment are quite close to sinusoidal as shown in Fig. 11. Accordingly, Filter 3 is deemed to be effective for use in the system 400 of Fig. 4.

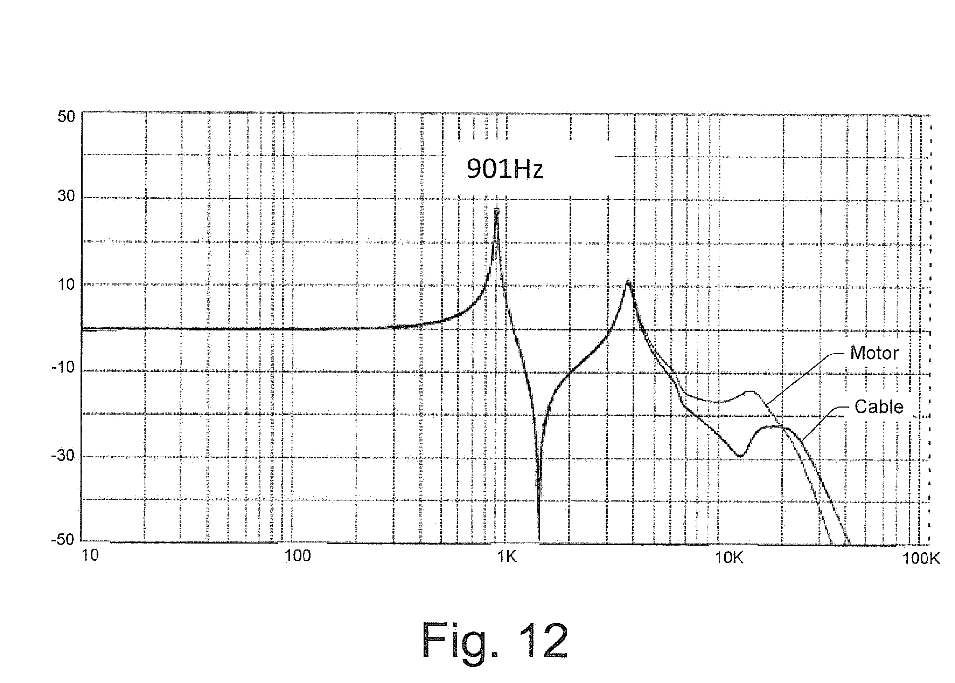

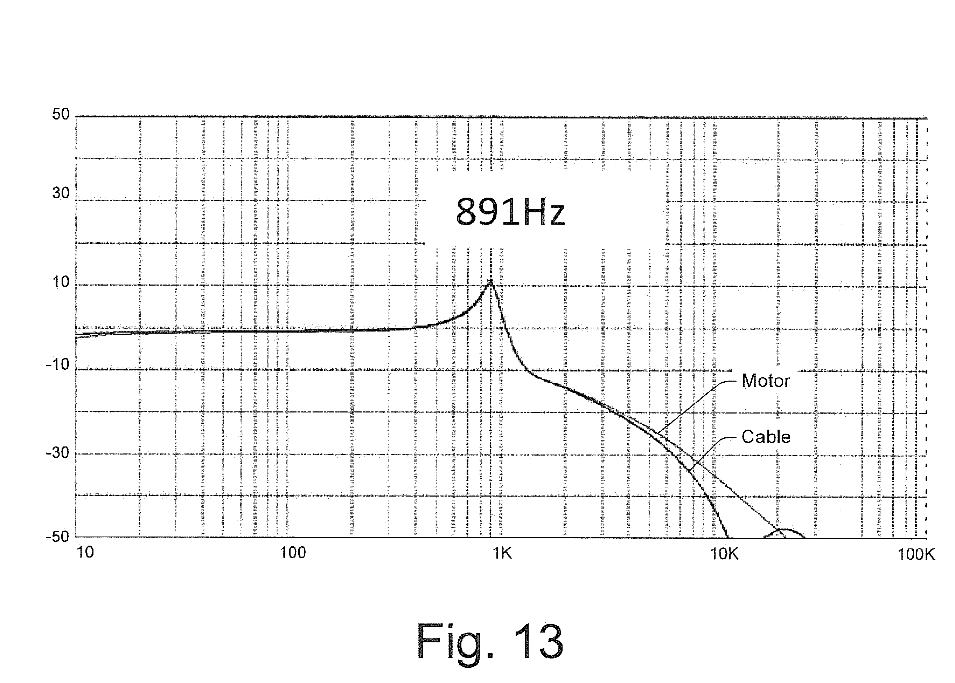

As to Filter 4, modeling was performed for the system 400 of Fig. 4 and the frequency response characteristics are shown in Fig. 12. As shown in Fig. 12, the resonance frequency is shifted to about 901 Hz. Further, the peak voltage at the downhole main cable is about 6670 V versus the peak voltage rating of about 7070 V of the cable, and the peak voltage at the ESP motor is about 6258 V versus the peak voltage rating of about 7070 V of the motor. The voltage and current waveforms of the downhole equipment are also quite close to sinusoidal as shown in Fig. 13. Accordingly, Filter 4 is deemed to be effective for use in the system 400 of Fig. 4.

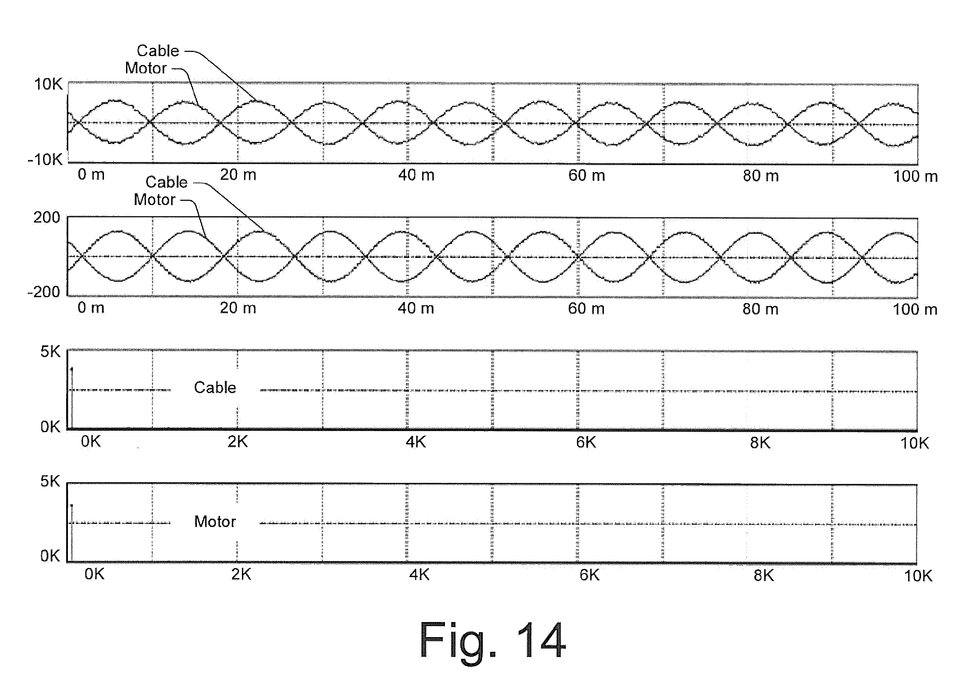

To demonstrate use of Filter 3 for different system parameters, the length of the subsea cable 440 of the system 400 was increased from about 2.5 km to about 25 km. Modeling results for Filter 3 applied to such system parameters are shown for frequency response in Fig. 13. As shown in Fig. 13, the resonance frequency is shifted to about 891 Hz. The peak voltage at the downhole main cable was about 5590 V versus the peak voltage rating of about 7070 V of the cable, and the peak voltage at the ESP motor is about 5290 V versus the peak voltage rating of about 7070 V of the motor (note, the voltage is lower partly because of the voltage drop on the subsea cable). For Filter 3, the voltage and current waveforms of the downhole equipment are also quite close to sinusoidal as shown in Fig. 14. Accordingly, Filter 3 is deemed effective even with a subsea cable having a length of about 25 km.

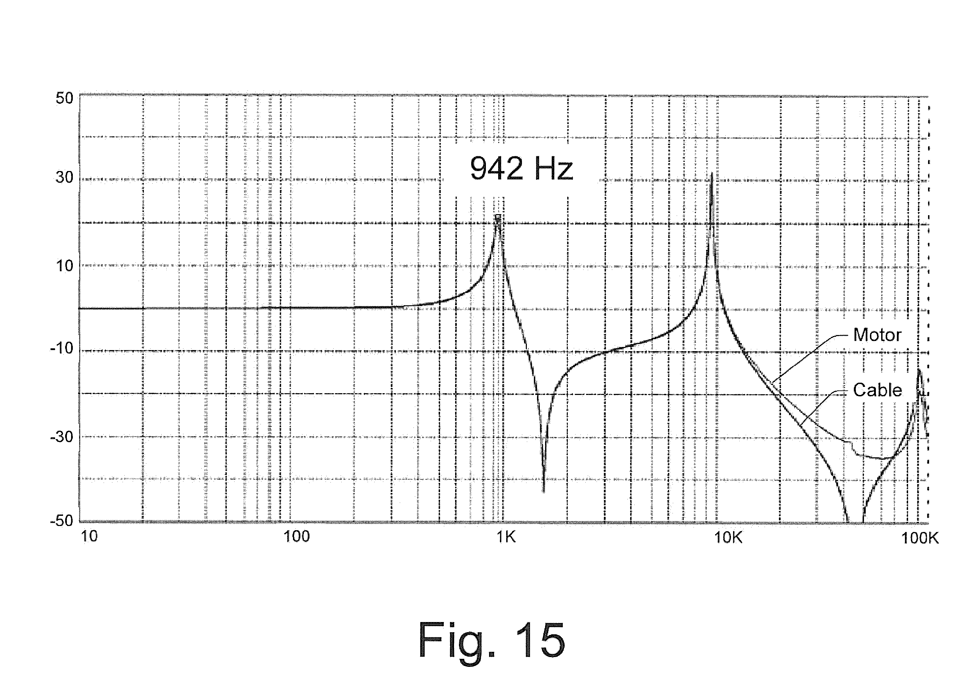

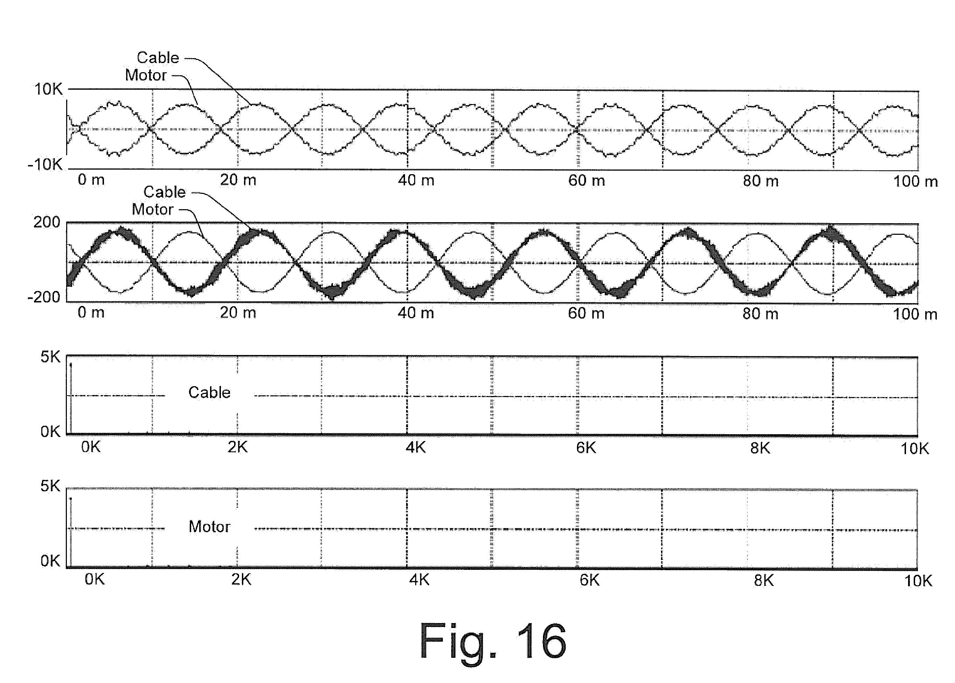

To further demonstrate the usefulness of Filter 3, the length of the subsea cable 440 of the system 400 of Fig. 4 was reduced to about 25 m, which essentially means that there are no subsea cables; noting that the downhole cable length was also reduce to about 600 m. For such a system, using Filter 3, modeling results for frequency response are shown in Fig. 15. As shown in Fig. 15, the first resonance frequency is shifted to about 942 Hz. The peak voltage at the downhole main cable is about 6882 V versus the peak voltage rating of about 7070 V of the cable, and the peak voltage at the ESP motor is about 6564 V versus the peak voltage rating of about 7070 V of the motor. For this example, the voltage waveforms of the downhole equipment are quite close to sinusoidal as shown in Fig. 16. While some current ripples exist at the downhole cable, the performance of Filter 3 in this example is deemed to be acceptable.

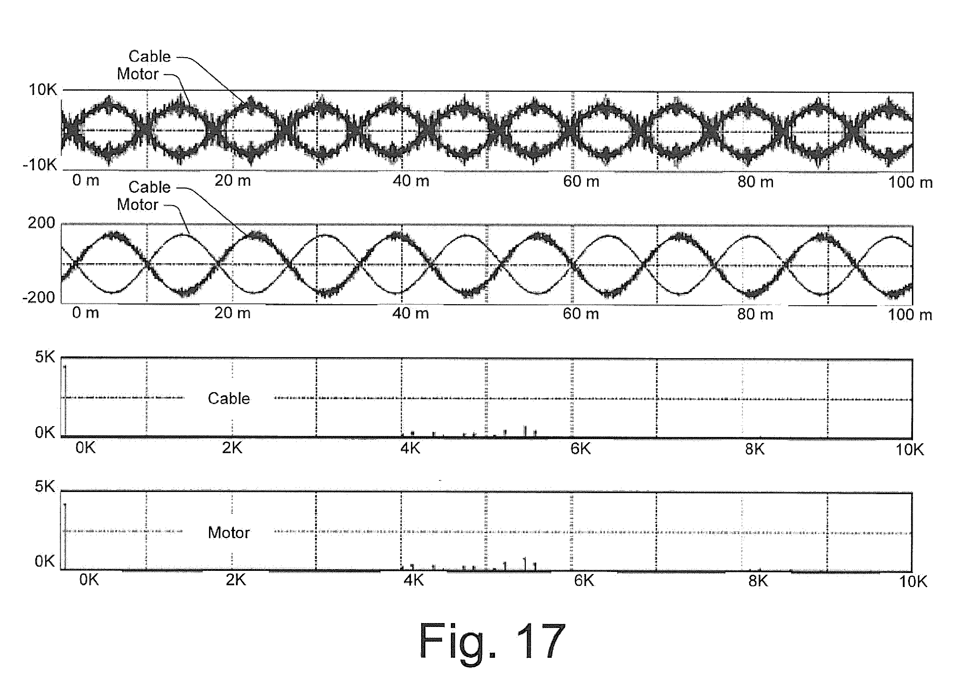

Modeling was also performed using a MVD that employed a cascade power cells technique. For example, referring to the system 400 of Fig. 4, the MVD configuration was modified to include a cascade power cells design. Modeling results for such a system without a load filter (e.g., unfiltered) show that the peak voltage at the downhole main cable is about 8802 V versus the peak voltage rating of about 7070 V of the cable, and that the peak voltage at the ESP motor is about 9228 V versus the peak voltage rating of about 7070 V of the motor. The simulated voltage and current waveforms at the downhole cable and the downhole motor are shown in Fig. 17. As demonstrated by the model, without a load filter, the downhole equipment could be damaged over time.

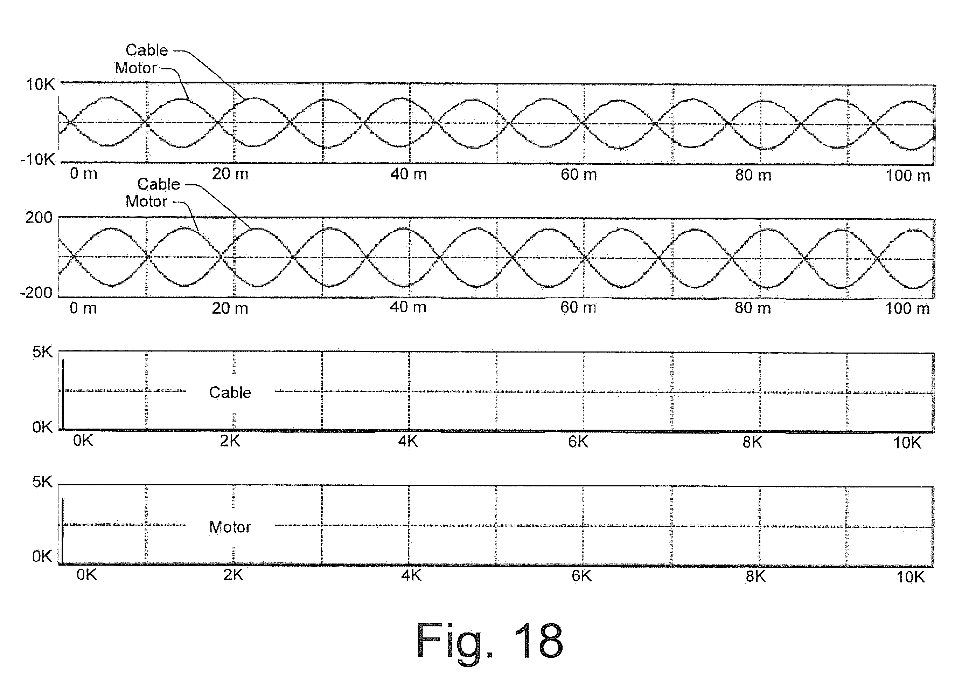

To demonstrate the usefulness of Filter 3 to the aforementioned cascade power cells MVD, modeling was performed where the simulated voltage and current waveforms at the downhole cable and the downhole motor are quite sinusoidal as shown in Fig. 18. The peak voltage at the downhole main cable is about 6299 V versus the peak voltage rating of about 7070 V of the cable, and the peak voltage at the ESP motor is about 5967 V versus the peak voltage rating of about 7070 V of the motor.

As demonstrated in the modeling of unfiltered and filtered systems, given one or more criteria for a MVD, a load filter may be provided with selected L and C values that can perform adequately for various parameters of a cabled ESP system. A load filter may be deemed a "universal" load filter for one or more criteria as it can prove effective for two types of MVDs, which are commercially available, as well as various configurations of cable leading to an ESP system, whether that ESP system is subsea or other.

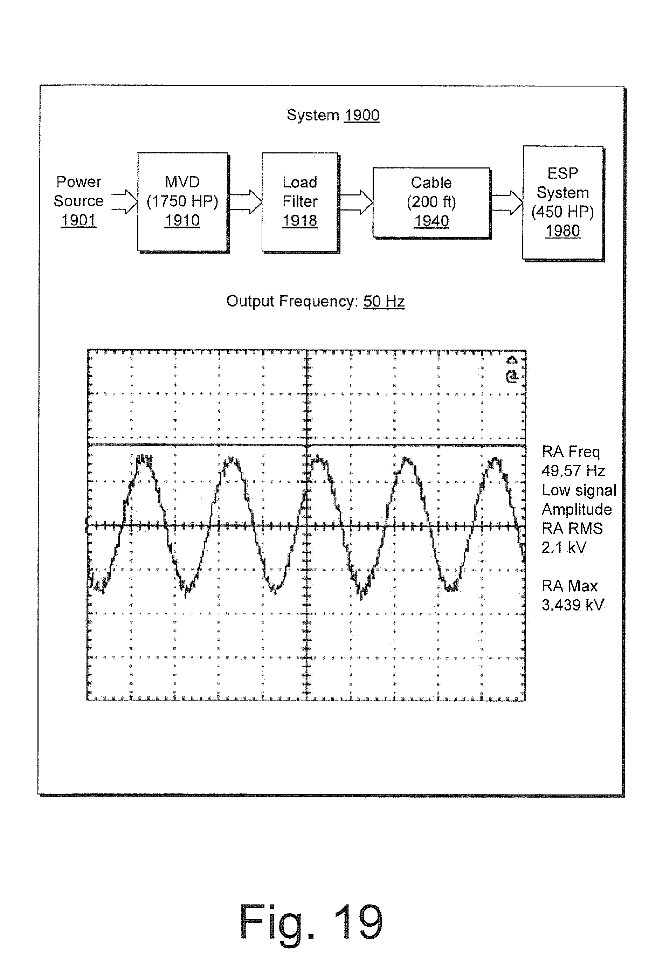

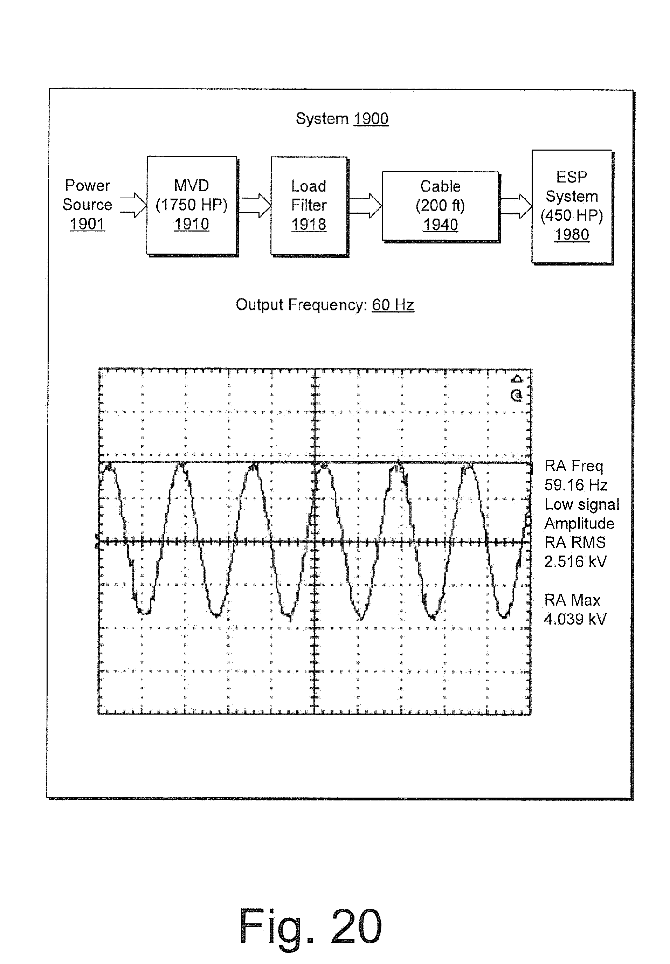

To demonstrate effectiveness of a method of selecting load filter parameters, a load filter was constructed according to the method and subject to trials in an ESP test well with a MVD. Figs. 19 and 20 show results from a physical system 1900 that included a power supply 1901, a MVD 1910, a load filter 1918 (e.g., a load filter according to selection blocks 514 and 518 of the method 510 of Fig. 5), a cable 1940 and an ESP system 1980. The results in Figs. 19 and 20 correspond to trials that were performed in an electric submersible pump test well where the load filter 1918 was connected to output of the 1750 HP MVD 1910. The cable 1940 has a length of about 200 ft and the ESP system 1980 included a motor rated at about 450 HP, 2600 V, 104 A at about 60 Hz.

In Fig. 19, the plot shows a voltage waveform at the output of the 1750 HP MVD with a load filter using a 50Hz output frequency. In Fig. 20, the plot shows a voltage waveform at the output of the 1750 HP MVD with the load filter using a 60Hz output frequency. As shown in the plots of Fig. 19 and Fig. 20, measured voltage waveforms are very close to sinusoidal. Accordingly, the load filter 1918 (e.g., per the method 510) performed adequately for the trial system 1900.

Conclusion

Although only a few examples have been described in detail above, those skilled in the art will readily appreciate that many modifications are possible in the examples. Accordingly, all such modifications are intended to be included within the scope of this disclosure as defined in the following claims. In the claims, means-plus-function clauses are intended to cover the structures described herein as performing the recited function and not only structural equivalents, but also equivalent structures. Thus, although a nail and a screw may not be structural equivalents in that a nail employs a cylindrical surface to secure wooden parts together, whereas a screw employs a helical surface, in the environment of fastening wooden parts, a nail and a screw may be equivalent structures. It is the express intention of the applicant not to invoke 35 U.S.C. § 112, paragraph 6 for any limitations of any of the claims herein, except for those in which the claim expressly uses the words "means for" together with an associated function.

**Claims**

1. A medium voltage drive for driving a motor of an electric submersible pump, the medium voltage drive comprising:

    inverter circuitry that comprises an output for output of power; and
    a load filter connected to the output that comprises inductors and capacitors that comprise inductance (L) and capacitance (C) values that determine a resonance frequency ($f_r$) value within a range from approximately 750 Hz to approximately 1000 Hz according to the equation

$$f_r = (2\pi(LC)^{0.5})^{-1}.$$

2. The medium voltage drive of claim 1 wherein the output of the inverter circuitry outputs a voltage up to approximately 6 kV.

3. The medium voltage drive of claim 1 wherein the output of the inverter circuitry outputs a multi-level pulse-width modulated voltage signal.

4. The medium voltage drive of claim 3 wherein the inductors and capacitors of the load filter filter the multi-level pulse-width modulated voltage signal to generate a waveform that approximates a sinusoidal waveform.

5. The medium voltage drive of claim 1 wherein the inductance and capacitance values are approximately 1.6 mH and approximately 20 μF, respectively.

6. The medium voltage drive of claim 5 wherein the resonance frequency value is approximately 890 Hz.

7. The medium voltage drive of claim 1 wherein the inductance and capacitance values are approximately 0.8 mH and approximately 40 μF, respectively.

8. The medium voltage drive of claim 7 wherein the resonance frequency value is approximately 890 Hz.

9. The medium voltage drive of claim 1 wherein the output outputs power signals that comprise a frequency in a range from approximately 0 Hz to approximately 120 Hz.

10. The medium voltage drive of claim 1 wherein the inductance (L) comprises an inductance value in a range from approximately 0.8 mH to approximately 2.2 mH and wherein the capacitance (C) comprises a capacitance value in a range from approximately 20 μF to approximately 40 μF.

11. A method comprising:

    selecting one or more criteria for a resonance frequency;
    selecting inductance and capacitance values for a load filter based at least in part on the one or more criteria;
    modeling a system that comprises a medium voltage drive, the load filter, cables and an electric submersible pump driven by an electric motor to generate modeling results;
    analyzing the modeling results for one or more peak frequencies and for cleanliness of sinusoidal waveforms;
    based on the analyzing of the modeling results, deciding if the load filter is acceptable;
    altering one or more parameters of the cables;
    re-modeling the system with the one or more altered parameters of the cables to generate additional modeling results;
    analyzing the additional modeling results for one or more peak frequencies and for cleanliness of sinusoidal waveforms;

based on the analyzing of the additional modeling results, deciding if the load filter is acceptable; and

if the deciding decides that the load filter is acceptable, building the load filter, otherwise repeating at least the selecting inductance and capacitance values to select at least one different inductance or capacitance value.

12. The method of claim 11 wherein the selecting one or more criteria for a resonance frequency comprises selecting a lower limit of approximately 750 Hz and selecting an upper limit of approximately 1000 Hz.

13. The method of claim 11 wherein the analyzing the modeling results for one or more peak frequencies comprises comparing a voltage for one of the one or more peak frequencies to a voltage limit of a physical piece of equipment for use in a system that includes a medium voltage drive, cables and an electric submersible pump driven by an electric motor.

14. A system comprising:

a medium voltage drive that comprises a load filter;

cables that comprise an overall length in a length range of approximately 25 m to approximately 25 km; and

an electric submersible pump that comprises an electric motor,

wherein the load filter maintains output from the medium voltage drive at voltages below rated voltages of the cables and the electric motor.

15. The system of claim 14 wherein the medium voltage drive is configured to output voltages up to approximately 6 kV.

16. The system of claim 14 wherein the load filter comprises inductors and capacitors that comprise inductance (L) and capacitance (C) values that determine a resonance frequency ($f_r$) value within a range from approximately 750 Hz to approximately 1000 Hz according to the equation $f_r = (2\pi (LC)^{0.5})^{-1}$ wherein the inductance (L) comprises an inductance value in a range from approximately 0.8 mH to approximately 2.2 mH and wherein the capacitance (C) comprises a capacitance value in a range from approximately 20 $\mu$F to approximately 40 $\mu$F.

17. The system of claim 16 wherein the inductance and capacitance values are approximately 1.6 mH and approximately 20 $\mu$F, respectively.

18. The system of claim 17 wherein the resonance frequency value is approximately 890 Hz.

19. The system of claim 16 wherein the inductance and capacitance values are approximately 0.8 mH and approximately 40 $\mu$F, respectively.

20. The system of claim 19 wherein the resonance frequency value is approximately 890 Hz.

Fig. 1

Fig. 2

Delta 310

Wye 330

Equation 350

$$f_r = \frac{1}{2\pi\sqrt{LC}}$$

$f_r$ = Resonance Frequency
$L$ = Inductance
$C$ = Capacitance

## Fig. 3

Fig. 4

Method <u>510</u>

| | |
|---|---|
| Select Frequency Limit/Range <u>514</u> | **Filter 1**<br><br>$f_r = 1186$ Hz<br>$L = 0.9$ mH<br>$C = 20$ μF |
| Select Inductance and Capacitance <u>518</u> | **Filter 2**<br><br>$f_r = 1186$ Hz<br>$L = 1.8$ mH<br>$C = 10$ μF |
| Model <u>522</u> | **Filter 3**<br><br>$f_r = 890$ Hz<br>$L = 1.6$ mH<br>$C = 20$ μF |
| Trial <u>526</u> | **Filter 4**<br><br>$f_r = 890$ Hz<br>$L = 0.8$ mH<br>$C = 40$ μF |

# Fig. 5

Fig. 6

Fig. 7

Fig. 8

EP 2 654 201 A2

Fig. 9

Fig. 10

Cable
Motor

10K

-10K
0 m    20 m    40 m    60 m    80 m    100 m

Cable
Motor

200

-200
0 m    20 m    40 m    60 m    80 m    100 m

5K

Cable

0K
0K    2K    4K    6K    8K    10K

5K

Motor

0K
0K    2K    4K    6K    8K    10K

# Fig. 11

Fig. 12

EP 2 654 201 A2

Fig. 13

Fig. 14

Fig. 15

Cable
Motor

10K

-10K
0 m          20 m          40 m          60 m          80 m          100 m

Cable
Motor

200

-200
0 m          20 m          40 m          60 m          80 m          100 m

5K

Cable

0K
0K          2K          4K          6K          8K          10K

5K

Motor

0K
0K          2K          4K          6K          8K          10K

# Fig. 16

Fig. 17

Fig. 18

Fig. 19

Fig. 20